# EUROPEAN PATENT APPLICATION

(11) **EP 4 632 404 A1**
(43) Date of publication of application: **15.10.2025**
(21) Application number: 25167212.7
(22) Date of filing: 28.03.2025
(51) Int. Cl.: G01R 31/3835, G01R 31/388

(54) **METHOD FOR CORRECTING BATTERY STATE OF CHARGE, SYSTEM, POWER DISTRIBUTION BOX, BATTERY PACK AND DEVICE**

(30) Priority: 29.03.2024 CN 202410394088
(71) Applicant: BYD Company Limited, Shenzhen, Guangdong 518118 (CN)
(72) Inventor: DENG, Linwang, Shenzhen, 518118 (CN); CAO, Huili, Shenzhen, 518118 (CN); LI, Xiaoqian, Shenzhen, 518118 (CN); FENG, Tianyu, Shenzhen, 518118 (CN)
(74) Representative: Mathys & Squire

(57) **Abstract**

The present disclosure discloses a method for correcting a battery state of charge, a battery management system, a storage medium, a power distribution box, a battery pack and an electric energy device. The method for correcting a battery state of charge includes: a target tolerance range of a battery state of charge is determined based on a preset interval that a real-time electric quantity characteristic parameter of a battery falls. Target tolerance ranges corresponding to any adjacent preset intervals are different. A current detected battery state of charge is corrected based on the target tolerance range. The method and system according to the present disclosure can improve estimation accuracy of the battery state of charge, thereby greatly avoiding the jump of the battery state of charge, and helping to more accurately monitor and manage the battery state of charge.

## Description

### FIELD

The present discloses relates to the technical field of batteries, and specifically, to a method for correcting battery state of charge, a battery management system, a nonvolatile readable storage medium, a power distribution box, a battery pack and an electric energy device.

### BACKGROUND

In the related art, battery state of charge (SOC) is estimated mainly by methods such as a Kalman filter method, an ampere-hour integration method and an open circuit voltage method. However, these methods have some problems in practical applications, that is, since there are different estimation errors in different SOC intervals, and these methods do not fully take these error differences into account during correction of an SOC, which may lead to SOC jump when full charge or full discharge occurs.

### SUMMARY

The present disclosure is intended to solve at least one of the technical problems existing in the related art. Therefore, an objective of the present disclosure is to provide a method for correcting a battery's state of charge. The method can improve estimation accuracy of the battery's state of charge, thereby effectively avoiding a jump in the battery's state of charge, and helping to more accurately monitor and manage battery state of charge.

A second objective of the present disclosure is to provide a battery management system.

A third objective of the present disclosure is to provide a nonvolatile readable storage medium.

A fourth objective of the present disclosure is to provide a power distribution box.

A fifth objective of the present disclosure is to provide a battery pack.

A sixth objective of the present disclosure is to provide an electric energy device.

To achieve the above objective, a method for correcting battery state of charge according to an embodiment of a first aspect of the present disclosure includes: a target tolerance range of battery state of charge is determined based on a preset interval that a real-time electric quantity characteristic parameter of a battery falls. Target tolerance ranges corresponding to any adjacent preset intervals are different. A current detected battery state of charge is corrected based on the target tolerance range.

In the method for correcting battery state of charge according to the embodiment of the present disclosure, the target tolerance range of the battery state of charge is determined based on the preset interval that the real-time electric quantity characteristic parameter of the battery falls. This means that the system classifies electric quantity characteristic parameters of the battery into different preset intervals, and each preset interval corresponds to one target tolerance range. This range reflects an allowable error in estimating battery state of charge in this interval, and target tolerance ranges corresponding to any adjacent preset intervals are different. This design takes characteristic changes of the battery in different operating states into account, so that the system can set a more accurate target tolerance range for the battery in operating states. The current detected battery state of charge is corrected based on the determined target tolerance range to ensure that a corrected state of charge falls within the target tolerance range. By this correction method, the jump problem in the battery state of charge caused by an estimation error can be solved, and the corrected battery state of charge more accurately reflects an actual situation, which helps to improve accuracy and reliability of battery management.

In some embodiments, the electric quantity characteristic parameter includes an open circuit voltage, and the preset interval includes a plateau region and a slope region of a battery state of charge - open circuit voltage curve. A target tolerance range corresponding to the plateau region is greater than a target tolerance range corresponding to the slope region.

In some embodiments, the electric quantity characteristic parameter further includes standing duration of the battery; and when the battery meets a static voltage correction condition, the target tolerance range tends to decrease with an increase in the standing duration of the battery.

In some embodiments, that the battery meets a static voltage correction condition includes that the standing duration of the battery reaches corresponding minimum allowable standing duration at a current temperature.

In some embodiments, when the standing duration of the battery reaches a corresponding preset voltage-stabilized standing duration at the current temperature, the target tolerance range is less than or equal to a preset standing tolerance range. The preset voltage-stabilized standing duration is greater than the minimum allowable standing duration.

In some embodiments, that a current detected battery state of charge is corrected based on the target tolerance range includes: a difference between a theoretical battery state of charge corresponding to the electric quantity characteristic parameter and the target tolerance range is determined. The current detected battery state of charge is corrected to the difference when the current detected battery state of charge is less than the difference.

In some embodiments, that a current detected battery state of charge is corrected based on the target tolerance range includes: a sum of a theoretical battery state of charge corresponding to the electric quantity characteristic parameter and the target tolerance range is determined. The current detected battery state of charge is corrected to the sum when the current detected battery state of charge is greater than the sum.

In some embodiments, that a current detected battery state of charge is corrected based on the target tolerance range includes: a difference between and a sum of a theoretical battery state of charge corresponding to the electric quantity characteristic parameter and the target tolerance range are determined. The current detected battery state of charge is not corrected when the current detected battery state of charge is greater than the difference and less than the sum.

To achieve the above objective, a battery management system according to an embodiment of a second aspect of the present disclosure includes: at least one processor; and a memory in communication connection with the at least one processor. A computer program executable by the at least one processor is stored in the memory, and when the at least one processor executes the computer program, the method for correcting a battery state of charge according to the above embodiment is implemented.

In the battery management system according to the embodiment of the present disclosure, the processor can improve estimation accuracy of battery state of charge by executing the computer program for implementing the method for correcting a battery state of charge according to the above embodiment, thereby greatly avoiding a jump in the battery state of charge, and helping to more accurately monitor and manage the battery state of charge.

To achieve the above objective, a nonvolatile readable storage medium according to an embodiment of a third aspect of the present disclosure stores a computer program. When the computer program is executed, the method for correcting battery state of charge according to the above embodiment is implemented.

In the nonvolatile readable storage medium according to the embodiment of the present disclosure, by the method for correcting battery state of charge according to the above embodiment, estimation accuracy of battery state of charge can be improved, thereby greatly avoiding a jump in the battery state of charge, and helping to more accurately monitor and manage the battery state of charge.

To achieve the above objective, a power distribution box according to an embodiment of a fourth aspect of the present disclosure includes: the battery management system according to the above embodiment.

In the power distribution box according to the embodiment of the present disclosure, by the battery management system according to the above embodiment, estimation accuracy of battery state of charge can be improved, thereby greatly avoiding a jump in battery state of charge, and helping to more accurately monitor and manage the battery state of charge.

To achieve the above objective, a battery pack according to an embodiment of a fifth aspect of the present disclosure includes: a power distribution box. The power distribution box is in signal connection with the battery, and the power distribution box is the power distribution box according to the above embodiment.

In the battery pack according to the embodiment of the present disclosure, the power distribution box is in signal connection with the battery, to receive and process various signals and data of the battery in real time. The power distribution box can determine a target tolerance range of a battery state of charge based on a real-time electric quantity characteristic parameter of the battery, and correct a current detected battery state of charge, to improve estimation accuracy of the battery state of charge, thereby greatly avoiding a jump in battery state of charge, and implementing intelligent monitoring and management of the battery state of charge.

To achieve the above objective, an electric energy device according to an embodiment of a sixth aspect of the present disclosure includes the power distribution box according to the above embodiment and/or the battery pack according to the above embodiment.

In the electric energy device according to the embodiment of the present disclosure, by the power distribution box according to the above embodiment and/or the battery pack according to the above embodiment, a target tolerance range of a battery state of charge can be determined based on a real-time electric quantity characteristic parameter of the battery, and a current detected battery state of charge can be corrected, to improve estimation accuracy of the battery state of charge, thereby greatly avoiding a jump in battery state of charge, and implementing intelligent monitoring and management of the battery state of charge.

Some of the additional aspects and advantages of the present disclosure are set forth in the following description, and some become clear from the following description, or are learned by practice of the present disclosure.

### BRIEF DESCRIPTION OF THE DRAWINGS

The above and/or additional aspects and advantages of the present disclosure become clear and readily comprehensible from the description of embodiments with reference to the following accompanying drawings.
FIG. 1 is a flowchart of a method for correcting battery state of charge according to an embodiment of the present disclosure;
FIG. 2 is a schematic diagram of a battery state of charge - open circuit voltage curve according to an embodiment of the present disclosure;
FIG. 3 is a schematic diagram showing correction of a current detected battery state of charge based on a threshold according to an embodiment of the present disclosure;
FIG. 4 is an overall flowchart of a method for correcting battery state of charge according to an embodiment of the present disclosure;
FIG. 5 is a block diagram of a battery management system according to an embodiment of the present disclosure;
FIG. 6 is a block diagram of a power distribution box according to an embodiment of the present disclosure;
FIG. 7 is a block diagram of a battery pack according to an embodiment of the present disclosure;
FIG. 8 is a block diagram of an electric energy device according to an embodiment of the present disclosure; and
FIG. 9 is a block diagram of an electric energy device according to another embodiment of the present disclosure.

Reference signs:
electric energy device 100;
battery pack 1;
battery 10; power distribution box 20;
battery management system 21;
processor 211; memory 212.

### DETAILED DESCRIPTION

Embodiments of the present disclosure are described in detail below. The embodiments described with reference to the accompanying drawings are exemplary.

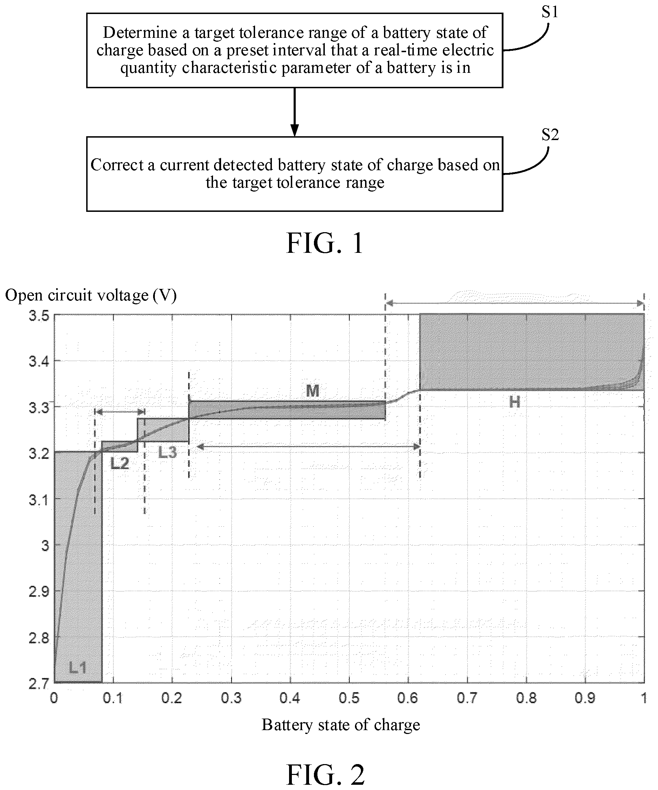

A method for correcting a battery state of charge is described below with reference to FIGS. 1 to 4.

FIG. 1 is a flowchart of a method for correcting battery state of charge according to an embodiment of the present disclosure. As shown in FIG. 1, the method for correcting a battery state of charge includes at least steps S1 and S2, specifically as follows:
S1: A target tolerance range of a battery state of charge is determined based on a preset interval that a real-time electric quantity characteristic parameter of a battery falls.

In some embodiments, the electric quantity characteristic parameter may mean various characteristic parameters that affect a battery state of charge, such as a voltage, a current, a temperature and standing duration. These parameters can describe a current operating state and characteristics of the battery. For example, the voltage of the battery can reflect a charging and discharging state of the battery, the current can indicate a charging or discharging rate of the battery, and the temperature can affect internal resistance and energy efficiency of the battery. The standing duration can reflect a time that it takes for a chemical reaction inside the battery to reach a relatively balanced state.

In some embodiments, the real-time electric quantity characteristic parameter of the battery can be acquired by various sensors or a battery management system. For example, a current sensor, a temperature sensor, a voltage sensor and other devices are used for real-time monitoring. These sensors can be directly connected to the battery or placed around the battery, and collect data in real time for analysis by the battery management system. For example, the current sensor records a current change of the battery, the voltage sensor monitors a voltage fluctuation, and the temperature sensor measures a temperature change. The battery management system can record operation history of the battery, including start and end times of charging and discharging. By analysis of these records, the system can calculate standing duration of the battery when no charging or discharging operation is performed. Therefore, these electric quantity characteristic parameters collected in real time provide accurate real-time data for the system, which further improves estimation accuracy of the battery state of charge.

In some embodiments, the preset intervals may be defined based on an operating state, charging and discharging characteristics, temperature and other factors of the battery, and each interval denotes a different state that the battery may be in. The target tolerance range may be a reference range when the battery state of charge is corrected, and is used to ensure that a corrected SOC is within a proper error range.

In some embodiments, target tolerance ranges corresponding to any adjacent preset intervals are different, which ensures that in a different battery operating state, the target tolerance range can be adjusted based on a change in the battery state.

S2: A current detected battery state of charge is corrected based on the target tolerance range.

In some embodiments, correcting the current detected battery state of charge based on the target tolerance range can ensure that the corrected battery state of charge falls within the target tolerance range, so as to eliminate an estimation error and cause the battery state of charge to reflect an actual situation more accurately. By correcting the battery state of charge, the system can avoid a jump in the battery state of charge caused by an estimation error and ensure smooth transition of the battery state of charge, and reliability and stability of the battery management system are improved.

In the method for correcting battery state of charge according to the embodiment of the present disclosure, the target tolerance range of the battery state of charge is determined based on the preset interval that the real-time electric quantity characteristic parameter of the battery falls. This means that the system classifies electric quantity characteristic parameters of the battery into different preset intervals, and each preset interval corresponds to one target tolerance range. This range reflects an allowable error in estimating battery state of charge in this interval, and target tolerance ranges corresponding to any adjacent preset intervals are different. This design takes characteristic changes of the battery in different operating states into account, so that the system can set a more accurate target tolerance range for the battery in operating states. The current detected battery state of charge is corrected based on the determined target tolerance range to ensure that a corrected state of charge falls within the target tolerance range. By this correction method, a jump problem in the battery state of charge caused by an estimation error can be avoided, and the corrected battery state of charge more accurately reflects an actual situation, which helps to improve accuracy and reliability of battery management.

In some embodiments, the electric quantity characteristic parameter includes an open circuit voltage. The open circuit voltage may mean a voltage of the battery when the battery is not connected to a circuit, that is, a voltage value measured when no current flows. The open circuit voltage is an important characteristic parameter of the battery, which reflects a standing state of the battery, with a change closely related to the battery state of charge. By monitoring the open circuit voltage, the system can obtain information about the current battery state of charge. Understanding the battery state of charge is crucial for the battery management system, as it affects performance and available energy of the battery. Therefore, by measuring the open circuit voltage, the system can monitor the state of the battery in real time and provide basic data for estimation of the battery state of charge.

In some embodiments, the open circuit voltage can be obtained by directly connecting the voltage sensor or a measuring instrument to a positive electrode and a negative electrode of the battery. These sensors can measure the open circuit voltage of the battery in real time, provide information about the current state of the battery, and provide the data to the battery management system for analysis.

In some embodiments, the preset interval includes a plateau region and a slope region of a battery state of charge - open circuit voltage curve. The battery state of charge - open circuit voltage curve may include a charging curve, a discharging curve, a standing curve, and the like. The charging curve can describe a relationship between a state of charge and a corresponding open circuit voltage of the battery during charging. The discharging curve can describe a relationship between a state of charge and a corresponding open circuit voltage of the battery during discharging. The standing curve can describe a relationship between a state of charge and a corresponding open circuit voltage of the battery in a standing state. Through the analysis of these curves, the battery state of charge can be understood more comprehensively and accurately, to provide a more accurate basis for estimation of the battery state of charge.

In some embodiments, plateau regions may mean regions on the battery state of charge - open circuit voltage curve. The voltage in each of these regions changes slowly or relatively smoothly, and are less likely to change dramatically with the charging and discharging state of the battery. In the plateau region, a voltage identification is relatively low, an ability to correct the battery state of charge is relatively poor, requirements for estimation are relatively low, and an allowable error range is larger. Therefore, a larger target tolerance range can be set corresponding to the plateau region to ensure flexibility of estimation.

Slope regions may mean other regions on the battery state of charge - open circuit voltage curve, and the voltage in each of these regions changes significantly with the charging and discharging state of the battery, thereby forming a slope-like curve. In the slope region, a voltage identification is relatively high, an ability to correct the battery state of charge is relatively high, requirements for estimation are higher, and an allowable error range is smaller. Therefore, a smaller target tolerance range can be set corresponding to the slope region to ensure the estimation accuracy in this region. That is, a target tolerance range corresponding to the plateau region is greater than a target tolerance range corresponding to the slope region.

FIG. 2 is a schematic diagram of a battery state of charge - open circuit voltage curve according to an embodiment of the present disclosure. As shown in FIG. 2, when a software module is invoked, a system first samples a voltage and determine a region where the voltage is. If the voltage is in a plateau region (region L2, M or H in FIG. 2), the system sets a target tolerance range corresponding to the plateau region. On the contrary, if the voltage is in a slope region (region L1 or L3 in FIG. 2), the system sets a target tolerance range corresponding to the slope region. The target tolerance range of the slope region is less than that of the plateau region.

Specifically, division of the plateau regions and the slope regions is performed through the characteristics of the battery voltage. In a slope region with an identification, a relationship between the voltage and battery state of charge (SOC) is more sensitive, and the SOC corresponding to voltage has high resolution, so that the system can estimate the battery state of charge more accurately. Therefore, there is a smaller target tolerance range in the slope region. For example, in the L1 slope region, the voltage is between 3.1 V and 3 V, and a corresponding SOC difference is less than 2%. In contrast, in a relatively stable plateau region, the SOC corresponding to the voltage has lower resolution, so that the estimation of battery state of charge by the system may not be accurate enough, and the plateau region has a larger target tolerance range. For example, in the L2 plateau region, the voltage is between 3.2 V and 3.3 V, and a corresponding SOC difference is about 10%. That is, when there is a voltage fluctuation or sampling error, the estimation accuracy of the battery state of charge is much less in the plateau region than in the slope region. Therefore, the SOC error is set to a smaller target tolerance range in the slope region.

In some embodiments, to adapt to different SOC values, linear interpolation can be used to set target tolerance ranges under different SOC values, so as to ensure that the estimation accuracy of the battery state of charge in the whole slope region can be reasonably controlled. Details are shown in Table 1 below:

**Table 1 Correspondence between an SOC and a target tolerance range**

| | | | | | | | | | |
|---|---|---|---|---|---|---|---|---|---|
| SOC | 0 | 8 | 14 | 22 | 56 | 61 | 95 | 98 | 100 |
| Tolerance | 0 | 1 | 4 | 4 | 6 | 4 | 6 | 3 | 1 |

As shown in Table 1, the SOC column in the table denotes different values of battery state of charge, while the Tolerance column denotes corresponding target tolerance ranges. The purpose of this table is to set different target tolerance ranges based on the SOC in voltage regions, so as to improve estimation accuracy of the battery state of charge. It can be observed from the table that the target tolerance range increases with the increase in the SOC in the slope region (0-8%). This reflects that for different ranges of the SOC in the slope region, the accuracy and stability of estimation of battery state of charge are improved by adjusting the target tolerance range.

In some embodiments, the electric quantity characteristic parameter includes not only the open circuit voltage of the battery, but also standing duration. The standing duration may mean duration during which the battery is in a standing state. A method for determining the standing state may be to estimate and infer the standing state based on a running state and characteristics of the battery, such as a current detection method, a voltage variation method and a temperature stabilization method. The current detection method may mean that the system determines a standing state by detecting a current of the battery. If the current is continuously near a minimum value, it can be determined that the battery is in the standing state. The voltage variation method may mean that the system monitors a voltage change of the battery, and can infer that the battery is in a standing state when the voltage change is very small or stable. The voltage variation method may mean that the system monitors a voltage change of the battery, and can infer that the battery is in a standing state when the battery is at a low temperature and has less change in temperature.

In some embodiments, when the battery meets a static voltage correction condition, the target tolerance range tends to decrease with an increase in the standing duration of the battery.

The static voltage correction condition may mean a state when the battery is not charged or discharged. When the battery is in a static state, the voltage of the battery is relatively stable, and can be used to estimate the battery state of charge. In this case, the system can adjust the electric quantity characteristic parameter of the battery to improve estimation accuracy of battery state of charge. In this case, the electrical characteristics of the battery are more affected by static factors than by dynamic charging or discharging.

Specifically, at the beginning, the system determines a target tolerance range of a battery state of charge based on an electric quantity characteristic parameter of the battery. When the system detects that the battery is in a static state, a static voltage correction process is started. The system starts to measure standing duration of the battery and continues to monitor a current status of the battery. With the increase in standing duration of the battery in a static state, an internal chemical reaction and charge distribution of the battery may gradually tend to be balanced, and the electric quantity characteristics are relatively stable. The system gradually reduces the target tolerance range of the battery state of charge. This shows that after the system takes the standing duration of the battery into account, requirements for estimation of the battery state of charge are gradually raised to reflect a real state of the battery more accurately.

Therefore, by this method, the system gradually narrows the target tolerance range after taking the battery standing duration and the static voltage state of the battery into account, thereby improving the estimation accuracy of battery state of charge. This helps to avoid a jump in the battery state of charge caused by an estimation error and ensures accuracy and reliability of the battery management system.

In some embodiments, that the battery meets a static voltage correction condition includes that the standing duration of the battery reaches corresponding minimum allowable standing duration at a current temperature. The standing duration may be duration during which the battery remains relatively still when not charged or discharged. The length of this duration can reflect a degree to which an internal charge distribution and chemical reaction of the battery are balanced. Corresponding minimum allowable standing duration of the battery at different temperatures may be a preset threshold, which means that under the current temperature condition, the system requires the battery to go through at least such a long standing time to ensure estimation accuracy.

Specifically, in a system design stage, minimum allowable standing duration of the battery at each temperature can be determined through an experiment or simulation studies. This duration is related to a battery type, chemical characteristics and a manufacturer's specifications. For example, the system can set minimum allowable standing duration at different temperatures to adapt to different environmental conditions. In a high-temperature environment, due to a high reaction speed of the battery, it may only take standing duration of 2 hours to meet the static voltage correction condition.

Further, when the system detects that the battery is in a relatively static state, that is, the current is 0 or close to 0, and the battery standing duration reaches minimum allowable standing duration at a current temperature, the system believes that the battery meets the static voltage correction condition. Once the battery meets this condition, the system starts the static voltage correction process. In this process, the system can adjust the target tolerance range of the battery state of charge to improve the estimation accuracy of battery state of charge.

For example, it is assumed that in a low-temperature environment, the system sets the minimum allowable standing duration as 8 hours. After the battery stands at a low temperature for 8 hours, the system believed that the battery has reached a relatively static state, and can correct a static voltage. Therefore, the static voltage correction condition is met when the standing duration of the battery reaches corresponding minimum allowable standing duration at a current temperature.

In some embodiments, when the standing duration of the battery reaches a corresponding preset voltage-stabilized standing duration at the current temperature, the target tolerance range is less than or equal to a preset standing tolerance range. The preset voltage-stabilized standing duration is greater than the minimum allowable standing duration.

In some embodiments, the preset voltage-stabilized standing duration may mean a preset time required for the battery to reach a stable voltage in a static state at a specific temperature. This duration can be determined based on a battery type, a temperature condition, historical data and other factors.

In some embodiments, the preset standing tolerance range is preset by the system, and reflects an estimated error range during standing of the battery at different temperatures. This range can be determined based on an experiment or experience, and can be adjusted based on battery characteristics and environmental conditions.

In some embodiments, when the standing duration of the battery reaches a corresponding preset voltage-stabilized standing duration at the current temperature, the system can adjust the target tolerance range. In this case, the target tolerance range can become more accurate, because the battery has gone through a standing time that is long enough, and the state of the battery has been relatively stable during this period of time. The target tolerance range may be set to be less than or equal to the preset standing tolerance range, and therefore the reduction of the target tolerance range can more accurately reflect actual battery state of charge.

Specifically, in the system design stage, the preset voltage-stabilized standing duration of the battery at each temperature can be determined based on an experiment or simulation studies. For example, at 25°C, the battery may need to stand for 8 hours to reach a relatively stable voltage. This duration may vary with the change in temperature.

Further, the system begins to determine whether the voltage is in a static state. When the voltage is still dynamic, the target tolerance range of the battery state of charge remains unchanged. When the system detects that the battery voltage is in a static state, that is, the current is 0 or close to 0, a current stop time is denoted as T1, and a current time is denoted as T2. A standing time is ΔT = T2 - T1. If the time difference ΔT meets a required minimum standing time, it is believed that the battery stands relatively fully, and the static voltage of the battery state of charge can be corrected. In this case, the target tolerance range of the battery state of charge remains unchanged. With the extension of the standing time, the target tolerance range of the battery state of charge begins to decrease linearly until the preset voltage-stabilized standing time is up, and the target tolerance range of the battery state of charge becomes close to 0%.

In some embodiments, different minimum allowable standing times and preset voltage-stabilized standing times are defined for different temperature ranges, specifically as shown in Table 2 below:

**Table 2 Correspondence between a temperature and a minimum allowable standing time and a voltage-stabilized standing time**

| Temperature/°C | <=-10 | 0 | 10 | >=25 |
|---|---|---|---|---|
| Minimum allowable standing time (hour) | 10 | 8 | 4 | 2 |
| Preset voltage-stabilized standing times (hour) | 32 | 24 | 16 | 8 |

As shown in Table 2, the Temperature/°C column in the table indicates different temperature values, and the minimum allowable standing time and the preset voltage-stabilized standing time are also different at different temperature values. With the increase of temperature, the minimum allowable standing time and the preset voltage-stabilized standing time gradually decrease.

In some embodiments, the correction process for the battery state of charge can be explained based on the above two tables. Specifically, when a software system is started, SOC = 5%, and this value is a detected value displayed by an instrument or a display screen. When the voltage is in a slope region (SOC = 4%), SOC = 4% herein is a theoretical value obtained by querying an SOC-voltage mapping relationship based on the voltage, and the target tolerance range of the battery state of charge is 0.5%. If dynamic voltage correction is performed in this case, the SOC is corrected to 4.5%. If the temperature is 25°C in this case and the standing time exceeds 8 hours, and the target tolerance range of the battery state of charge becomes close to 0%, the SOC is corrected to 4%, reaching highest accuracy.

When software is started, the current SOC is 16%, the voltage is in a plateau region (SOC = 14%), and the target tolerance range of the battery state of charge is 4%. If a method for correcting a battery state of charge is dynamic voltage correction, the SOC remains at 16%. Because the voltage is in the plateau region in this case, with a low identification, it is impossible to determine whether the SOC queried based on the voltage in this case is accurate, and therefore a larger target tolerance range of the battery state of charge is given. If the temperature is 10°C in this case, when the target tolerance range of the battery state of charge is 2%, the standing time is at least 10 hours. When the standing time exceeds 10 hours, if the voltage remains unchanged all the time, the SOC gradually approaches 14% with time. When the standing time reaches 16 hours, the voltage is believed to have reached a stable state at this temperature, and the SOC is corrected to 14%.

Generally, this method dynamically adjusts the target tolerance range of the battery state of charge based on different situations, considering an impact of a temperature and a standing time, so as to improve accuracy and stability of correction and ensure a good effect in terms of user experience.

In some embodiments, that a current detected battery state of charge is corrected based on the target tolerance range includes: a difference between a theoretical battery state of charge corresponding to the electric quantity characteristic parameter and the target tolerance range is determined. The current detected battery state of charge is corrected to the difference when the current detected battery state of charge is less than the difference.

The theoretical battery state of charge is an accurate battery state of charge obtained by querying a mapping relationship between a battery state of charge and an open circuit voltage through the open circuit voltage. In practical application, the mapping relationship between a battery state of charge and an open circuit voltage can be obtained through an experiment or simulation. For example, a set of experimental data is set up, open circuit voltages of the battery under different states of charge are recorded to fit a mapping model. When the system detects the open circuit voltage of the battery, a corresponding theoretical battery state of charge is found based on the mapping relationship.

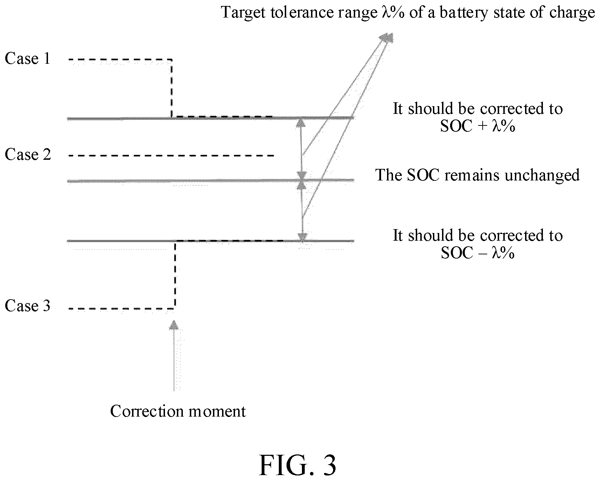

For example, in a case 3 shown in FIG. 3, assuming that the target tolerance range of the battery state of charge is λ, if the current detected battery state of charge is less than the difference between the theoretical battery state of charge and the target tolerance range λ before correction, the current detected battery state of charge is corrected to the difference between the theoretical battery state of charge and the target tolerance range λ.

In some embodiments, that a current detected battery state of charge is corrected based on the target tolerance range includes: a sum between a theoretical battery state of charge corresponding to the electric quantity characteristic parameter and the target tolerance range is determined. The current detected battery state of charge is corrected to the sum when the current detected battery state of charge is greater than the sum.

For example, in a case 1 shown in FIG. 3, assuming that the target tolerance range of the battery state of charge is λ, if the current detected battery state of charge is greater than the sum of the theoretical battery state of charge and the target tolerance range λ before correction, the current detected battery state of charge is corrected to the sum of the theoretical battery state of charge and the target tolerance range λ.

In some embodiments, that a current detected battery state of charge is corrected based on the target tolerance range includes: a difference between and a sum of a theoretical battery state of charge corresponding to the electric quantity characteristic parameter and the target tolerance range are determined. The current detected battery state of charge is not corrected when the current detected battery state of charge is greater than the difference and less than the sum.

For example, in a case 2 shown in FIG. 3, if the current detected battery state of charge is greater than the difference between the theoretical battery state of charge and the target tolerance range λ and less than the sum of the theoretical battery state of charge and the target tolerance range λ, that is, when the current detected battery state of charge is within the target tolerance range, the battery state of charge remains unchanged.

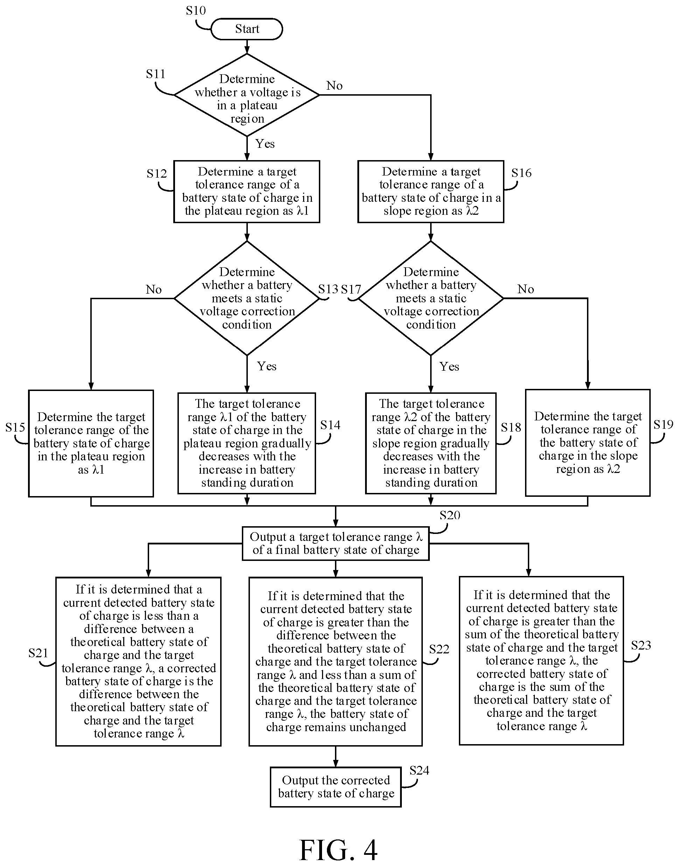

FIG. 4 is an overall flowchart of a method for correcting a battery state of charge according to an embodiment of the present disclosure. As shown in FIG. 4, the method for correcting a battery state of charge includes at least steps S10 to S24, specifically as follows:
S10: The process is started.
S11: It is determined whether a voltage is in a plateau region, and if so, step S12 is performed, or if not, step S16 is performed.
S12: A target tolerance range of a battery state of charge in the plateau region is determined as λ1.
S13: It is determined whether a battery meets a static voltage correction condition, and if so, step S14 is performed, or if not, step S15 is performed.
S14: The target tolerance range λ1 of the battery state of charge in the plateau region gradually decreases with the increase in battery standing duration.
S15: A target tolerance range of the battery state of charge is determined as λ1.
S16: A target tolerance range of a battery state of charge in a slope region is determined as λ2.
S17: It is determined whether a battery meets a static voltage correction condition, and if so, step S18 is performed, or if not, step S19 is performed.
S18: The target tolerance range λ2 of the battery state of charge in the slope region gradually decreases with the increase in battery standing duration.
S19: The target tolerance range of the battery state of charge in the slope region is determined as λ2.
S20: A target tolerance range λ of a final battery state of charge is output.
S21: If it is determined that a current detected battery state of charge is less than a difference between a theoretical battery state of charge and the target tolerance range λ, a corrected battery state of charge is the difference between the theoretical battery state of charge and the target tolerance range λ.
S22: If it is determined that the current detected battery state of charge is greater than the difference between the theoretical battery state of charge and the target tolerance range λ and less than a sum of the theoretical battery state of charge and the target tolerance range λ, the battery state of charge remains unchanged.
S23: If it is determined that the current detected battery state of charge is greater than the sum of the theoretical battery state of charge and the target tolerance range λ, the corrected battery state of charge is the sum of the theoretical battery state of charge and the target tolerance range λ.
S24: The corrected battery state of charge is output.

To sum up, in the method for correcting battery state of charge according to the embodiment of the present disclosure, by intelligent adjustment of the target tolerance range, the battery state of charge is effectively corrected based on a region where the battery is located and a static condition thereof. This method can estimate battery state of charge more accurately, improve system performance, and optimize flexibility and accuracy of estimation especially when taking battery operating characteristics in different operating regions and a static state into account, thereby improving battery use safety and system stability.

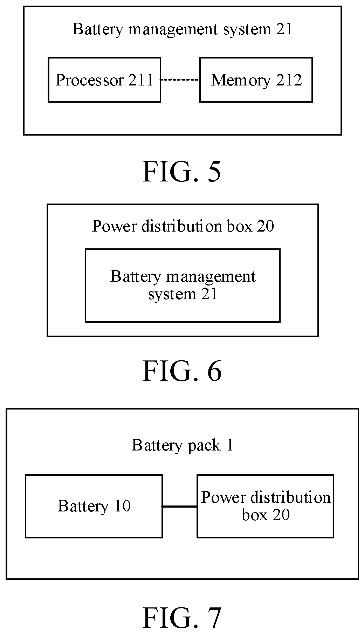

A battery management system according to an embodiment of the present disclosure is described below with reference to FIG. 5.

FIG. 5 is a block diagram of a battery management system according to an embodiment of the present disclosure. As shown in FIG. 5, a battery management system 21 includes: a memory 212 and at least one processor 211.

The at least one processor 211 may be one processor 211, or multiple processors 211 such as two processors 211, three processors 211, five processors 211, eight processors 211 or ten processors 211. These processors 211 each may be a general-purpose processor (such as a central processing unit (CPU)) or a special-purpose processor, specifically depending on application and requirements of the battery management system 21.

In some embodiments, the memory 212 may include a random access memory (RAM), a read-only memory (ROM), a flash memory, or the like. The RAM is configured to temporarily store runtime data and programs. The ROM is configured to store read-only data. The flash memory is usually configured to store, for example, an operating system, an application program and user data, for a long term.

In some embodiments, the memory 212 is mainly configured to store a computer program of the battery manager system 21. The computer program includes the method for correcting a battery state of charge according to the above embodiment. The memory 212 is in communication connection with the at least one processor 211. The processor 211 is responsible for executing a computer program stored in the memory 212 to implement the method for correcting a battery state of charge according to the above embodiment. During the execution, the processor 211 performs data processing, logical judgment, conditional branching and other operations to ensure that battery state of charge can be corrected and estimated as required.

In the battery management system 21 according to the embodiment of the present disclosure, the processor 211 can improve estimation accuracy of the battery state of charge by executing the computer program for implementing the method for correcting battery state of charge according to the above embodiment, thereby greatly avoiding a jump in the battery state of charge, and helping to more accurately monitor and manage the battery state of charge.

An embodiment of the present disclosure further provides a nonvolatile readable storage medium storing a computer program. When the computer program is executed, the method for correcting a battery state of charge according to the above embodiment is implemented. For a specific implementation process of the method for correcting battery state of charge, reference may be made to the description of the above embodiment.

In the nonvolatile readable storage medium according to the embodiment of the present disclosure, by the method for correcting battery state of charge according to the above embodiment, estimation accuracy of the battery state of charge can be improved, thereby greatly avoiding a jump in the battery state of charge, and helping to more accurately monitor and manage the battery state of charge.

A power distribution box according to an embodiment of the present disclosure is described below with reference to FIG. 6.

FIG. 6 is a block diagram of a power distribution box according to an embodiment of the present disclosure. As shown in FIG. 6, the power distribution box 20 includes the battery management system 21 according to the above embodiment.

In some embodiments, the power distribution box 20 can be mounted in homes, industrial sites or vehicles to manage battery charging and discharging processes related to power supply. For example, in homes, the power distribution box 20 can be mounted in a solar photovoltaic system to manage charging and energy storage processes of a solar panel. The battery management system 21 can adjust charging and discharging policies based on a real-time voltage and charging state of the solar panel to ensure maximum utilization of solar energy. In industrial sites, the power distribution box 20 may be configured to control a battery power supply system of a factory device. The battery management system 21 can adjust the target tolerance range of the battery state of charge based on actual power consumption of the device and electric quantity characteristic parameters of the battery, so as to ensure stable power supply of the device. In an electric vehicle or a hybrid vehicle, the power distribution box 20 may be configured to manage charging and discharging processes of a power battery of the vehicle. The battery management system 21 can adjust the target tolerance range of the battery state of charge based on a vehicle driving state and the electric quantity characteristic parameters of the battery to ensure efficient energy consumption management and safe operation of the vehicle.

In the power distribution box 20 according to the embodiment of the present disclosure, by the battery management system 21 according to the above embodiment, estimation accuracy of battery state of charge can be improved, thereby greatly avoiding a jump in the battery state of charge, and helping to more accurately monitor and manage battery state of charge.

A battery pack according to an embodiment of the present disclosure is described below with reference to FIG. 7.

FIG. 7 is a block diagram of a battery pack according to an embodiment of the present disclosure. As shown in FIG. 7, the battery pack 1 includes: a battery 10 and a power distribution box 20.

In some embodiments, the battery 10 is used as a core component for energy storage in the battery pack 1. There may be various batteries 10, such as a lithium-ion battery and a lead-acid battery, which can be selected based on specific application requirements.

In some embodiments, the power distribution box 20 is a device connected to the battery 10, and is configured to manage and monitor charging and discharging processes of the battery 10 and estimate and control battery state of charge. The power distribution box 20 is in signal connection with the battery 10, and the power distribution box 20 is allowed to acquire real-time data and state information of the battery 10.

In the battery pack 1 according to the embodiment of the present disclosure, the power distribution box 20 is in signal connection with the battery 10, to receive and process various signals and data of the battery 10 in real time. The power distribution box 20 can determine a target tolerance range of a battery state of charge based on a real-time electric quantity characteristic parameter of the battery 10, and correct a current detected battery state of charge, to provide more accurate battery state information, so as to improve estimation accuracy of the battery state of charge, thereby greatly avoiding a jump in the battery state of charge, and implementing intelligent monitoring and management of the battery state of charge.

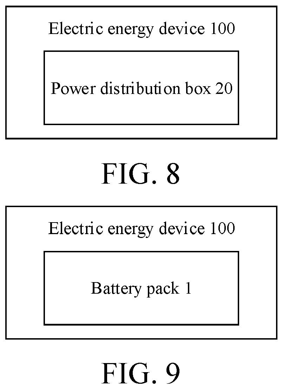

An embodiment of the present disclosure further provides an electric energy device 100. The electric energy device 100 includes the power distribution box 20 according to the above embodiment and/or the battery pack 1 according to the above embodiment. This means that the electric energy device 100 may include the power distribution box 20 (as shown in FIG. 8) only, or the electric energy device 100 may include both the power distribution box 20 and the battery 10 (as shown in FIG. 9), specifically depending on actual needs and an application environment.

If the electric energy device 100 is powered mainly by an external power source, for example, if the device that is fixed in one place and has a stable power source, only the power distribution box 20 may be needed to manage distribution and transmission of electric energy. In this case, the electric energy device 100 may include the power distribution box 20 only. However, for some vehicles, ships or aircraft, a hybrid power system may be adopted, including both an internal combustion engine and a motor. In this case, the power distribution box 20 is needed to manage electric energy from two different power sources, and the battery 10 is needed as a power source of the motor.

In some embodiments, the electric energy device 100 may be a vehicle, a ship, an aircraft, an electrical appliance, an energy storage cabinet, or the like.

In the electric energy device 100 according to the embodiment of the present disclosure, by the power distribution box 20 according to the above embodiment and/or the battery pack 1 according to the above embodiment, a target tolerance range of a battery state of charge can be determined based on a real-time electric quantity characteristic parameter of the battery 10, and a current detected battery state of charge can be corrected, to improve estimation accuracy of battery state of charge, thereby greatly avoiding a jump in the battery state of charge, and implementing intelligent monitoring and management of the battery state of charge.

In the description of this specification, the description with reference to the terms "an embodiment", "some embodiments", "an illustrative embodiment", "an example", "a specific example", or "some examples" means that specific features, structures, materials or characteristics described with reference to the embodiment or example are included in at least one embodiment or example of the present disclosure. In this specification, the illustrative expressions of the above terms do not necessarily refer to the same embodiment or example.

Although the embodiments of the present disclosure have been shown and described, it can be understood by a person of ordinary skill in the art that many changes, modifications, replacements and variations may be made to these embodiments without departing from the principles and purposes of the present disclosure, and the scope of the present disclosure is defined by the claims and equivalents thereof.

## Claims

1. A method for correcting a battery state of charge, comprising:
determining a target tolerance range of a battery state of charge based on a preset interval that a real-time electric quantity characteristic parameter of a battery falls, the target tolerance ranges corresponding to any adjacent preset intervals being different; and
correcting a current detected battery state of charge based on the target tolerance range.

2. The method according to claim 1, wherein
the electric quantity characteristic parameter comprises an open circuit voltage, and the preset interval comprises a plateau region and a slope region of a battery state of charge - open circuit voltage curve,
wherein the target tolerance range corresponding to the plateau region is greater than the target tolerance range corresponding to the slope region.

3. The method according to claim 2, wherein
the electric quantity characteristic parameter further comprises a standing duration of the battery; and
when the battery meets a static voltage correction condition, the target tolerance range tends to decrease with an increase in the standing duration of the battery.

4. The method according to claim 3, wherein the battery meeting the static voltage correction condition comprises that the standing duration of the battery reaches corresponding minimum allowable standing duration at a current temperature.

5. The method according to claim 4, wherein when the standing duration of the battery reaches a corresponding preset voltage-stabilized standing duration at the current temperature, the target tolerance range is less than or equal to a preset standing tolerance range, wherein the preset voltage-stabilized standing duration is greater than the minimum allowable standing duration.

6. The method according to any one of claims 1 to 5, wherein correcting the current detected battery state of charge based on the target tolerance range comprises:
determining a difference between a theoretical battery state of charge corresponding to the electric quantity characteristic parameter and the target tolerance range; and
correcting the current detected battery state of charge to the difference when the current detected battery state of charge is less than the difference.

7. The method according to any one of claims 1 to 5, wherein correcting the current detected battery state of charge based on the target tolerance range comprises:
determining a sum of a theoretical battery state of charge corresponding to the electric quantity characteristic parameter and the target tolerance range; and
correcting the current detected battery state of charge to the sum when the current detected battery state of charge is greater than the sum.

8. The method according to any one of claims 1 to 5, wherein correcting the current detected battery state of charge based on the target tolerance range comprises:
determining a difference between and a sum of a theoretical battery state of charge corresponding to the electric quantity characteristic parameter and the target tolerance range; and
skipping correcting the current detected battery state of charge when the current detected battery state of charge is greater than the difference and less than the sum.

9. A battery management system, comprising:
at least one processor; and
a memory in communication connection with the at least one processor,
a computer program executable by the at least one processor being stored in the memory, and when the at least one processor executes the computer program, the method for correcting a battery state of charge according to any one of claims 1 to 8 is implemented.

10. A nonvolatile readable storage medium storing a computer program, wherein the method for correcting a battery state of charge according to any one of claims 1 to 8 is implemented when the computer program is executed.

11. A power distribution box, comprising the battery management system according to claim 9.

12. A battery pack, comprising:
a battery; and
a power distribution box, the power distribution box being in signal connection with the battery, and the power distribution box being the power distribution box according to claim 11.

13. An electric energy device, comprising: the power distribution box according to claim 11 and/or the battery pack according to claim 12.
